# EUROPEAN PATENT APPLICATION

(11) **EP 1 189 378 A1**
(43) Date of publication of application: **20.03.2002**
(21) Application number: 01917698.1
(22) Date of filing: 30.03.2001
(51) Int. Cl.: H04K 1/00

(54) **FREQUENCY SHIFT TRANSCEIVER**

(30) Priority: 24.04.2000 JP 2000122942
(71) Applicant: Temco Japan Co., Ltd., Tokyo 168-0062 (JP)
(72) Inventor: FUJINO, Shouji, TEMCO JAPAN CO., LTD., Tokyo 168-0062 (JP)
(74) Representative: de Roquemaurel, Bruno
(86) International application number: JP0102750
(87) International publication number: WO0182517

(57) **Abstract**

The present invention relates to a frequency translation transceiver of a communication means employed in a limited group of members, the number of which is, for example, approximately 10 persons, wherein the transceiver is free from any illegal tapping and interference and characterized by comprising: a memory unit for storing and setting a plurality of frequencies and its own identification number; a receiver circuit for performing a scanning operation of the plurality of frequencies in its receiving mode to obtain an incoming signal; a detection circuit for extracting data of an identification number of the incoming signal having been received by the receiver circuit; and, a transmitter circuit for transmitting data of the own identification number together with an audio signal.

## Description

### FIELD OF THE INVENTION

The present invention relates to a frequency translation transceiver of a communication means employed in a limited group of members, the number of which members is, for example, approximately 10 persons, wherein the transceiver is free from any illegal tapping and interference.

### BACKGROUND OF THE INVENTION

In a conventional transceiver, communication is performed at a selected predetermined frequency, and is therefore relatively weak in preventing illegal tapping in communication. This is one of problems inherent in the conventional transceiver. Further, the conventional transceiver often interferes with the other communication units during its manually-conducted channel selection, which is required when a designated channel is already occupied.

Although there is suitable systems such as a multi-channel access system and the like in which any frequency is not fixed, such systems require a base station in communication, and are therefore complex in construction and expensive. Consequently, in an area where no base station is installed, these systems are not employed.

In view of these problems inherent in the prior art, the present invention was made. Therefore, it is an object of the present invention to provide a frequency translation transceiver, which is hard to illegally tap and is free from any interference and any cumbersomeness of the conventional manual channel selection.

### SUMMARY OF THE INVENTION

A frequency translation transceiver of the present invention is characterized in that the transceiver comprises: a memory unit for storing and setting a plurality of frequencies and its own identification number; a receiver circuit for performing a scanning operation of the plurality of frequencies in its receiving mode to obtain an incoming signal; a detection circuit for extracting data of an identification number of the incoming signal having been received by the receiver circuit; and, a transmitter circuit for transmitting data of the own identification number together with an audio signal.

In the transceiver of the present invention, preferably: the scanning operation of the plurality of frequencies stored in the memory unit is stopped when a sender depresses a PTT switch; a carrier is detected by receiving one of the plurality of frequency immediately after the end of the scanning operation; the data of the identification number is transmitted when the carrier is not detected; and, then the audio signal is transmitted.

Further, in the transceiver of the present invention, preferably: the scanning operation of the plurality of frequencies stored in the memory unit is stopped when the carrier is received by the receiving circuit; and, reception of the audio signal starts when the identification number is confirmed through authentication of the data of the identification number performed by the detection circuit.

### BRIEF DESCRIPTION OF THE DRAWING

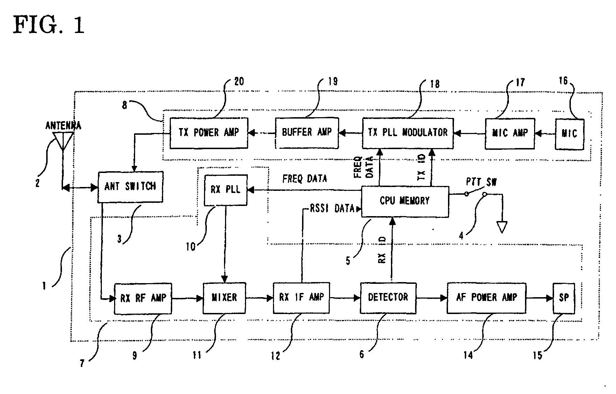

Fig. 1 is a block diagram of the frequency translation transceiver of the present invention, illustrating constituent elements of the transceiver.

### BEST MODE FOR CARRYING OUT THE INVENTION

With reference to the accompanying drawings, embodiments of the present invention will be described. Fig. 1 is a block diagram of a frequency translation transceiver 1 of the present invention, illustrating constituent elements of the transceiver 1. The transceiver is provided with: an antenna 2; an antenna switch 3 for automatically switching a transmitting and a receiving operation; a PTT (Push-To-Talk) switch 4; a memory unit 5; a receiver circuit 7, which includes a detection circuit 6 for detecting data of an identification number of an incoming signal; and, a transmitter circuit 8 for transmitting data of its own identification number together with an audio signal.

The receiving circuit 7 comprises: a receiver-side RR amplifier 9 for amplifying the incoming signal as it is in shape; a receiver-side phase lock loop 10; a mixer 11; a receiver-side intermediate frequency amplifier 12 for amplifying the signal having been converted into an intermediate frequency; the detection circuit 6; an AF power amplifier 14 for performing an amplifying operation to produce an audio frequency; and, a speaker 15. On the other hand, transmitter circuit 8 comprises: a microphone 16; a microphone amplifier 17; a transmitter-side phase lock loop 18; buffer amplifier 19; and, a transmitter-side power amplifier 20.

Set and stored in the memory unit 5 are: data of an identification number of each of groups, wherein the data permits a predetermined communication to be performed; and, a plurality of frequencies in a frequency band available in communication. In any time when any transmitting and receiving operation is not performed, predetermined ones of the plurality of frequencies having been stored in the memory unit are supplied to the receiver-side phase lock loop 10 in a predetermined order of transmission to repeat a scanning operation.

Next, the transmitting and receiving operation of the frequency translation transceiver of the present invention will be described. In operation, when a sender depresses a PTT switch 4, the scanning operation of the plurality of frequencies is stopped so that data of one of the plurality of frequencies stored in the memory unit 5 is transmitted to the transmitter-side phase lock loop 18, wherein the one of the plurality of frequencies is obtained immediately after the end of the scanning operation to become a transmitted frequency. Then, with respect to this transmitted frequency, detection of a carrier is performed.

When no carrier is detected, the data of the identification number having been issued from the memory unit 5 immediately after this detection is issued as a bit signal of the identification number, so that the audio signal picked up by the microphone 16 is stored in the memory unit 5 and is transmitted with a delay time of approximately 0.5 second in transmission. At this time, the data of the identification number is transmitted several times to ensure that the identification number is received by the side of the receiver without fail.

In the transmitter-side transceiver 1, as is in the side of the receiver, a plurality of frequencies having been stored and set in the memory unit 5 are supplied to the receiver-side phase lock loop 10 in a predetermined order so that a constant and high-speed scanning operation is repeatedly performed in a receiving mode without any stop.

Any signal received through the antenna 2 is amplified in its original shape by the receiver-side RF amplifier 9, and detected by the mixer 11 with the use of the frequencies which are supplied from the memory unit 5 in a predetermined order during the continuous scanning operation to reproduce a base band waveform. When the receiver-side intermediate frequency amplifier 12 detects an RSSI (Receiving Signal Strength Indicator), the transceiver is locked at the frequency to enter its receiving mode. In other words, when the RSSI is supplied to the memory unit 5 through the receiver-side intermediate frequency amplifier 12 so that the memory unit 5 catches the signal being equal or more than a predetermined level in strength, an instruction signal for starting a receiving operation is issued.

Then, the data of the identification number detected by the detection circuit 6 is compared with the data previously stored in the memory unit 5. Only when these data coincide with each other, the incoming audio signal is issued from the speaker 15 through the AF power amplifier 14. On the other hand, when any data of the identification number is not detected, or, when there is a difference between the detected data of the identification number and the data having been stored in the memory unit 5, any audio signal is not issued so that the scanning operation of the frequencies starts again.

When someone wants to transmit his message after completion of current communication, a new carrier frequency is determined when such someone or sender depresses the PTT button 6. Due to this, it is possible for the user to enjoy communication with the use of these frequencies, which are changed each time the transmitting and the receiving operation are performed.

### INDUSTRIAL APPLICABILITY

As described above, according to the present invention having the above construction, the frequencies used in communication are automatically changed regardless of the sender's will each time when the transmitting and the receiving operation are performed. Due to this, in each of the above-mentioned groups, it is hard for the pirate to illegally tap the communication performed through the transceivers of the present invention, which ensures that the communication is sufficiently protected in privacy. Further, since changes in frequency in the communication are automatically performed, the transceiver of the present invention is free from any cumbersome manual operation and also free from any interference with the other communication means. Furthermore, in the transceiver of the present invention, a complex procedure for setting the frequencies in communication between the base station and the transceivers or between the transceivers is not required. Due to this, it is possible to produce and therefore provide the transceiver of the present invention together with its entire system at a low cost.

## Claims

1. A frequency translation transceiver **characterized by** comprising: a memory unit for storing and setting a plurality of frequencies and its own identification number; a receiver circuit for performing a scanning operation of said plurality of frequencies in its receiving mode to obtain an incoming signal; a detection circuit for extracting data of an identification number of said incoming signal having been received by said receiver circuit; and, a transmitter circuit for transmitting data of said own identification number together with an audio signal.

2. The frequency translation transceiver as set forth in claim 1, wherein: said scanning operation of said plurality of frequencies stored in said memory unit is stopped when a sender depresses a PTT switch; a carrier is detected by receiving one of said plurality of frequency immediately after the end of said scanning operation; said data of said identification number is transmitted when said carrier is not detected; and, then said audio signal is transmitted.

3. The frequency translation transceiver as set forth in claim 1 or 2, wherein: said scanning operation of said plurality of frequencies stored in said memory unit is stopped when said carrier is received by said receiving circuit; and, reception of said audio signal starts when said identification number is confirmed through authentication of said data of said identification number performed by said detection circuit.

4. The frequency translation transceiver as set forth in claim 2, wherein: transmission of said audio signal is performed after a lapse of a predetermined period of time after said data of said identification number is transmitted.
